# EUROPÄISCHE PATENTSCHRIFT

(11) **EP 0 688 096 B1**
(45) Veröffentlichungstag und Bekanntmachung des Hinweises auf die Patenterteilung: **10.03.1999**
(21) Anmeldenummer: 95108517.4
(22) Anmeldetag: 02.06.1995
(51) Int. Cl.: H03F 1/02

(54) **Integrierte Schaltungsanordnung**
Integrated circuit
Circuit intégré

(30) Priorität: 16.06.1994 DE 4421072
(43) Veröffentlichungstag der Anmeldung: 20.12.1995
(73) Patentinhaber: TEMIC Semiconductor GmbH, 74072 Heilbronn (DE)
(72) Erfinder: Schnabel, Jürgen, D-74211 Leingarten (DE); Häfner, Horst, D-74080 Heilbronn (DE); Hammel, Hermann, D-74585 Rot am See (DE); Gutsch, Henrik, Dr., D-74081 Heilbronn (DE)
(74) Vertreter: Maute, Hans-Jürgen, Dipl.-Ing.

(56) Entgegenhaltungen:
- EP-A- 0 491 980
- EP-A- 0 522 786
- GB-A- 2 068 670
- US-A- 4 050 030

## Beschreibung

Die Erfindung betrifft eine integrierte Schaltungsanordnung (IC) nach dem Oberbegriff des Anspruchs 1. Derartige Schaltungsanordnungen mit zwei hintereinandergeschalteten Verstärkerstufen werden in ICs üblicherweise zur Signalverstärkung eingesetzt. Bei einer DC-Kopplung, d. h. bei direkt miteinander verbundenen Verstärkerstufen, wird die Offset-Spannung der ersten Verstärkerstufe in gleichem Maße wie deren Signalspannung mitverstärkt. Die daraus resultierende Arbeitspunktverschiebung der nachfolgenden zweiten Verstärkerstufe beeinträchtigt die Funktionsfähigkeit des ICs.

Eine Verschiebung der Arbeitspunkte ist durch den Einsatz einer AC-Kopplung vermeidbar. Hierzu wird ein Ausgang der ersten Verstärkerstufe über einen externen, außerhalb des ICs angeordneten Koppelkondensator mit einem Eingang der zweiten Verstärkerstufe verbunden. Mit einem derartigen in den Signalzweig eingefügten Koppelkondensator ist nur noch der AC-Anteil der am Ausgang der ersten Verstärkerstufe bereitgestellten Signalspannung zur zweiten Verstärkerstufe übertragbar; der DC-Anteil und somit auch die Offset-Spannung werden aus der Signalspannung ausgefiltert. Der Koppelkondensator ist als externes Bauteil ausgeführt, da er insbesondere zur Übertragung von NF-Signalspannungen relativ groß sein muß und folglich nicht in den IC integrierbar ist. Eine derartige AC-Kopplung ist jedoch kostspielig, da zu deren Realisierung ein zusätzliches externes Bauteil benötigt wird. Außerdem beansprucht dieses externe Bauteil zusätzliche Platinenfläche sowie zwei zusätzliche Anschlüsse am IC-Gehäuse. Letzteres ist als Hauptnachteil zu werten, da größere IC-Gehäuse neben einem höheren Preis auch schlechtere Hochfrequenz-Eigenschaften aufweisen.

Schaltungen wie oben diskutiert sind. z.B. aus GB-A-2 068 670 bekannt.

Der Erfindung liegt die Aufgabe zugrunde, eine Schaltungsanordnung gemäß dem Oberbegriff des Anspruchs 1 anzugeben, mit der eine Signalübertragung von der ersten Verstärkerstufe zur zweiten Verstärkerstufe ohne die eingangs erwähnten Nachteile realisierbar ist. Diese Aufgabe wird erfindungsgemäß durch die Merkmale im Kennzeichen des Patentanspruchs 1 gelöst. Vorteilhafte Ausgestaltungen und Weiterbildungen ergeben sich aus den Unteransprüchen.

In der erfindungsgemäßen Schaltungsanordnung weist die erste Verstärkerstufe zwei differentielle Ausgänge und die zweite Verstärkerstufe zwei hochohmige, vorzugsweise als MOS-Eingänge ausgeführte, differentielle Eingänge auf. Die Signalübertragung von der ersten Verstärkerstufe zur zweiten Verstärkerstufe erfolgt über eine AC-Koppelstufe, die als zwei in den IC integrierte Koppelkondensatoren ausgebildet ist. Jeweils einer der differentiellen Ausgänge der ersten Verstärkerstufe ist über einen der Koppelkondensatoren mit einem der differentiellen Eingänge der zweiten Verstärkerstufe verbunden. Um die Arbeitspunkte der zweiten Verstärkerstufe einzustellen, werden die beiden differentiellen Eingänge dieser Stufe über jeweils einen im IC vorgesehenen und als Widerstand geschalteten MOS-Transistor an einem ersten Versorgungsanschluß mit einer Versorgungsquelle verbunden. Den Gate-Anschlüssen dieser beiden als Widerstände geschalteten MOS-Transistoren wird vorzugsweise über einen zweiten Versorgungsanschluß ein Bezugspotential zugeführt. Da mit derartigen als Widerstände geschalteten MOS-Transistoren hohe Widerstandswerte herstellbar sind, sind auch mit kleinen Koppelkondensatoren große Zeitkonstanten der AC-Koppelstufe realisierbar.

Die erfindungsgemäße Schaltungsanordnung bietet folgende Vorteile:
- Sie läßt sich vollständig in einen IC integrieren und ist, da keine externen Bauteile benötigt werden, kostengünstig herstellbar.
- Das Gehäuse des ICs kann, da keine Anschlüsse für externe für die AC-Kopplung benötigte Bauteile erforderlich sind, klein gehalten werden. Dadurch erhält man gute Hochfrequenz-Eigenschaften der Schaltungsanordnung bei gleichzeitig gering gehaltenen Gehäusekosten.
- Aufgrund des differentiellen Aufbaus der Schaltungsanordnung werden Störungen der AC-gekoppelten Signalspannung, die beispielsweise durch Abweichungen der Widerstandskennlinien der beiden als Widerstände geschalteten MOS-Transistoren von der idealen Widerstandskennlinie verursacht werden, in einem weiten Spannungsbereich kompensiert. Infolgedessen weist die Schaltungsanordnung einen geringen Klirrfaktor auf. Die erste Verstärkerstufe kann somit mit hohen Signalpegeln betrieben werden, was zu einem günstigen Signalrauschverhältnis der AC-gekoppelten Signalspannung führt.
- Die Schaltungsanordnung eignet sich vorzüglich zur AC-Kopplung von NF-Signalspannungen, da mit kleinen, in den IC integrierbaren Koppelkondensatoren große Zeitkonstanten der AC-Koppelstufe realisierbar sind.

Die Schaltungsanordnung läßt sich überall dort einsetzen, wo die zur Verfügung stehende Halbleitertechnologie eine Integration von MOS-Transistoren und Koppelkondensatoren in einen IC zuläßt und wo eine AC-Kopplung, insbesondere von NF-Signalspannungen durchführbar sein soll.

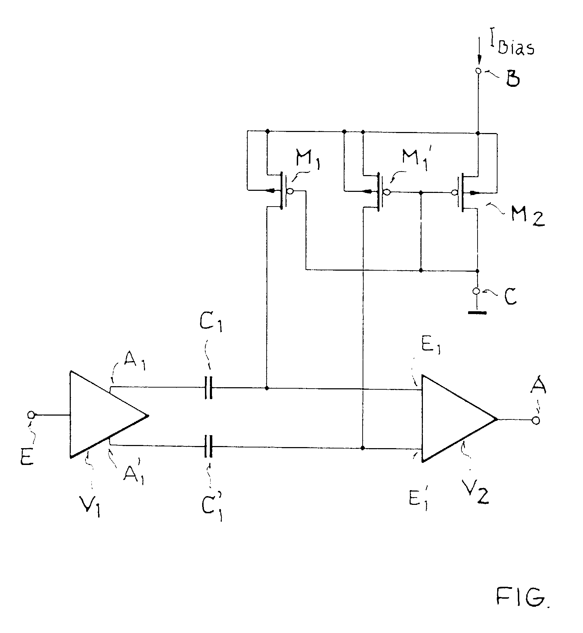

Die erfindungsgemäße Schaltungsanordnung wird im folgenden anhand eines in der Figur gezeigten Ausführungsbeispiels näher beschrieben. Gemäß der Figur weist die Schaltungsanordnung eine erste Verstärkerstufe V₁, eine zweite Verstärkerstufe V₂, eine AC-Koppelstufe mit zwei Koppelkondensatoren C₁ und C'₁, zwei als PMOS-Transistoren ausgeführte und als Widerstände geschaltete MOS-Transistoren M₁ und M'₁, sowie einen ebenfalls als PMOS-Transistor ausgeführten weiteren MOS-Transistor M₂ auf. Die erste Verstärkerstufe V₁ besitzt zwei niederohmige differentielle Ausgänge A₁, A'₁ und, da zusätzliches Rauschen bei hohen Verstärkungen vermieden werden soll, einen bipolaren Eingang E. Die zweite Verstärkerstufe V₂ ist als Instrumentenverstärker mit zwei differentiellen MOS-Eingängen E₁, E'₁, d. h. mit extrem hochohmigen differentiellen Eingängen, ausgebildet. Der Ausgang A₁ bzw. A'₁ der ersten Verstärkerstufe V₁ ist über den Koppelkondensator C₁ bzw. C'₁ mit dem Eingang E₁ bzw. E'₁ der zweiten Verstärkerstufe V₂ verbunden. Der Eingang E₁ bzw. E'₁ der zweiten Verstärkerstufe V₂ ist außerdem an den Drain-Anschluß des als Widerstand geschalteten MOS-Transistors M₁ bzw. M'₁ angeschlossen. Der Drain-Anschluß und der Gate-Anschluß des weiteren MOS-Transistors M₂ sowie die Gate-Anschlüsse der beiden als Widerstände geschalteten MOS-Transistoren M₁ und M'₁ sind am zweiten Versorgungsanschluß C miteinander verbunden und liegen auf Massepotential. Die Source-Anschlüsse der beiden als Widerstände geschalteten MOS-Transistoren M₁, M'₁ und der Source-Anschluß des weiteren MOS-Transistors M₂ sind am ersten Versorgungsanschluß B, in den der Arbeitsstrom I_{Bias} eingespeist wird, miteinander verbunden. Aufgrund des durch den weiteren MOS-Transistor M₂ fließenden Stromes stellt sich an dessen Source-Anschluß, d. h. am ersten Versorgungsanschluß B, ein Arbeitspotential ein. Die beiden als Widerstände geschalteten MOS-Transistoren M₁ und M'₁ werden hierdurch vorgespannt. Aufgrund eines geeigneten W/L-Verhältnisses der beiden als Widerstände geschalteten MOS-Transistoren M₁ und M'₁ (deutlich kleiner als 1, z. B. 2,5/600) und eines entsprechend dimensionierten Arbeitsstromes I_{Bias} ergibt sich an den Eingängen E₁ und E'₁ der zweiten Verstärkerstufe V₂ ein hoher Widerstand. Mit 20-pF-Koppelkondensatoren C₁, C'₁, die problemlos in den IC integrierbar sind, ist dann eine AC-Kopplung von NF-Signalen durchführbar.

Der Klirrfaktor der AC-gekoppelten Signalspannung ist wegen des differentiellen Aufbaus der Schaltungsanordnung auch bei Signalamplituden von 1 V kleiner als 1 %. Das Signal-Rausch-Verhältnis der über die Koppelkondensatoren C₁, C'₁ übertragenenen Signalspannung wird durch die AC-Kopplung kaum beeinflußt.

## Patentansprüche

1. Integrierte Schaltungsanordnung mit einer ersten Verstärkerstufe (V₁) und einer dieser nachgeschalteten zweiten Verstärkerstufe (V₂), wobei
- die erste Verstärkerstufe (V₁) zwei differentielle Ausgänge (A₁, A'₁) aufweist,
- die zweite Verstärkerstufe (V₂) zwei hochohmige differentielle Eingänge (E₁, E'₁) aufweist,
- die Schaltungsanordnung zur AC-Kopplung eine Koppelstufe mit zwei Koppelkondensatoren (C₁, C'₁) aufweist, welche jeweils einen der differentiellen Ausgänge (A₁ bzw. A'₁) der ersten Verstärkerstufe (V₁) mit einem der differentiellen Eingänge (E₁ bzw. E'₁) der zweiten Verstärkerstufe (V₂) verbinden,
dadurch gekennzeichnet, daß
- die Schaltungsanordnung zur Arbeitspunkteeinstellung der zweiten Verstärkerstufe (V₂) zwei als Widerstände geschaltete MOS-Transistoren (M₁, M'₁) aufweist, die einen ersten Versorgungsanschluß (B) mit jeweils einem der differentiellen Eingänge (E₁ bzw. E'₁) der zweiten Verstärkerstufe (V₂) verbinden.

2. Schaltungsanordnung nach Anspruch 1, dadurch gekennzeichnet, daß die differentiellen Eingänge (E₁, E'₁) der zweiten Verstärkerstufe (V₂) als MOS-Eingänge ausgeführt sind.

3. Schaltungsanordnung nach einem der vorherigen Ansprüche, dadurch gekennzeichnet, daß die zweite Verstärkerstufe (V₂) als Instrumentenverstärker ausgebildet ist.

4. Schaltungsanordnung nach einem der vorherigen Ansprüche, dadurch gekennzeichnet, daß die erste Verstärkerstufe (V₁) einen bipolaren differentiell oder asymmetrisch ausgeführten Eingang (E) aufweist.

5. Schaltungsanordnung nach einem der vorherigen Ansprüche, dadurch gekennzeichnet, daß zur Arbeitspunkteinstellung der beiden als Widerstände geschalteten MOS-Transistoren (M₁, M'₁) ein weiterer MOS-Transistor (M₂) vorgesehen ist, dessen Drain-Anschluß an einem zweiten Versorgungsanschluß (C) mit seinem Gate-Anschluß und mit den Gate-Anschlüssen der beiden als Widerstände geschalteten MOS-Transistoren (M₁, M'₁) verbunden ist, und dessen Source-Anschluß am ersten Versorgungsanschluß (B) mit den Source-Anschlüssen der beiden als Widerstände geschalteten MOS-Transistoren (M₁, M'₁) verbunden ist.

6. Schaltungsanordnung nach Anspruch 5, dadurch gekennzeichnet, daß der zweite Versorgungsanschluß (C) auf Massepotential liegt.

7. Schaltungsanordnung nach einem der vorherigen Ansprüche, dadurch gekennzeichnet, daß in den ersten Versorgungsanschluß (B) ein Arbeitsstrom (I_{Bias}) eingespeist wird.

8. Schaltungsanordnung nach einem der vorherigen Ansprüche, dadurch gekennzeichnet, daß die beiden als Widerstände geschalteten MOS-Transistoren (M₁, M'₁) und der weitere MOS-Transistor (M₂) als PMOS-Transistoren ausgebildet sind.

9. Verwendung einer Schaltungsanordnung nach einem der vorherigen Ansprüche zur AC-Kopplung von NF-Signalen.

## Claims

1. Integrated circuit arrangement including a first amplifier stage (V₁) and a following second amplifier stage (V₂) connected thereto, wherein,
- the first amplifier stage (V₁) comprises two differential outputs (A₁, A'₁),
- the second amplifier stage (V₂) comprises two high impedance differential inputs (E₁, E'₁),
- the circuit arrangement comprises a coupling stage including two coupling capacitors (C₁, C'₁) for ac-coupling purposes, said capacitors respectively connecting one of the differential outputs (A₁ or A'₁) of the first amplifier stage (V₁) to one of the differential inputs (E₁ or E'₁) of the second amplifier stage (V₂),
characterised in that
- the circuit arrangement comprises two MOS transistors (M₁, M'₁) which are connected up as resistances and are used for setting the working point of the second amplifier stage (V₂), said MOS transistors connecting a first supply terminal (B) to a respective one of the differential inputs (E₁ and E'₁) of the second amplifier stage (V₂).

2. Circuit arrangement in accordance with Claim 1, characterised in that the differential inputs (E₁, E'₁) of the second amplifier stage (V₂) are implemented as MOS inputs.

3. Circuit arrangement in accordance with any of the preceding Claims, characterised in that the second amplifier stage (V₂) is constructed as an instrument amplifier.

4. Circuit arrangement in accordance with any of the preceding Claims, characterised in that the first amplifier stage (V₁) comprises a bipolar input (E) that is implemented differentially or asymmetrically.

5. Circuit arrangement in accordance with any of the preceding Claims, characterised in that a further MOS transistor (M₂) is provided for setting the working point of the two MOS transistors (M₁, M'₁) which are connected up as resistances, the drain terminal of said further MOS transistor (M₂), together with its gate terminal and the gate terminals of the two MOS transistors (M₁, M'₁) which are connected up as resistances, being connected to a second supply terminal (C), and the source terminal of said further MOS transistor (M₂), together with the source terminals of the two MOS transistors (M₁, M'₁) which are connected up as resistances, being connected to the first supply terminal (B).

6. Circuit arrangement in accordance with Claim 5, characterised in that the second supply terminal (C) is connected to earth potential.

7. Circuit arrangement in accordance with any of the preceding Claims, characterised in that a working current (I_{Bias}) is supplied to the first supply terminal (B).

8. Circuit arrangement in accordance with any of the preceding Claims, characterised in that the two MOS transistors (M₁, M'₁) which are connected up as resistances and also the further MOS transistor (M₂) are implemented in the form of PMOS transistors.

9. The use of a circuit arrangement in accordance with any of the preceding Claims for ac-coupling LF signals.

## Revendications

1. Circuit intégré équipé d'un premier étage amplificateur (V₁) et d'un second étage amplificateur (V₂) disposé en aval de celui-ci,
- le premier étage amplificateur (V₁) comportant deux sorties différentielles (A₁, A'₁),
- le second étage amplificateur (V₂) présentant deux entrées différentielles (E₁, E'₁) à haute impédance,
- le circuit comportant, en vue du couplage alternatif, un étage de couplage avec deux condensateurs de couplage (C₁, C'₁), qui relient respectivement une des entrées différentielles (A₁, A'₁, respectivement) du premier étage amplificateur (V₁) à l'une des entrées différentielles (E₁, E'₁, respectivement) du second étage amplificateur (V₂),
caractérisé en ce que
- le circuit comporte, en vue du réglage des points de fonctionnement du second étage amplificateur (V₂), deux transistors MOS (M₁, M'₁) montés en résistances, qui relient une première borne d'alimentation (B) respectivement à l'une des entrées différentielles (E₁, E'₁, respectivement) du second étage amplificateur (V₂).

2. Circuit selon la revendication 1, caractérisé en ce que les entrées différentielles (E₁, E'₁) du second étage amplificateur (V₂) sont réalisées sous la forme d'entrées MOS.

3. Circuit selon l'une quelconque des revendications précédentes, caractérisé en ce que le second étage amplificateur (V₂) est réalisé sous la forme d'un amplificateur de mesure.

4. Circuit selon l'une quelconque des revendications précédentes, caractérisé en ce que le premier étage amplificateur (V₁) présente une entrée (E) réalisée de façon différentielle bipolaire ou asymétrique.

5. Circuit selon l'une quelconque des revendications précédentes, caractérisé en ce qu'en vue du réglage du point de fonctionnement des deux transistors MOS (M₁, M'₁) montés en résistances, un autre transistor MOS (M₂) est prévu, dont la borne de drain est reliée à une seconde borne d'alimentation (C) avec sa borne de grille et avec les bornes de grille des deux transistors MOS (M₁, M'₁) montés en résistances, et dont la borne de source est reliée à la première borne d'alimentation (B) avec les bornes de source des deux transistors MOS (M₁, M'₁) montés en résistances.

6. Circuit selon la revendication 5, caractérisé en ce que la seconde borne d'alimentation (C) se trouve au potentiel de la masse.

7. Circuit selon l'une quelconque des revendications précédentes, caractérisé en ce qu'un courant de fonctionnement (Iₚₒₗₐᵣᵢₛₐₜᵢₒₙ) est appliqué à la première borne d'alimentation (B).

8. Circuit selon l'une quelconque des revendications précédentes, caractérisé en ce que les deux transistors MOS (M₁, M'₁) montés en résistances et l'autre transistor MOS (M₂) sont réalisés sous la forme de transistors PMOS.

9. Utilisation d'un circuit selon l'une quelconque des revendications précédentes en vue du couplage alternatif de signaux à basse fréquence.
